Europäisches Patentamt

European Patent Office

Office européen des brevets

(11) Veröffentlichungsnummer: **0 350 609**
**A2**

## (12) EUROPÄISCHE PATENTANMELDUNG

(21) Anmeldenummer: 89109707.3

(22) Anmeldetag: 30.05.89

(51) Int. Cl.⁴ **G01R 31/28 , G01R 1/04**

(30) Priorität: 09.07.88 DE 3823367

(43) Veröffentlichungstag der Anmeldung:
17.01.90 Patentblatt 90/03

(84) Benannte Vertragsstaaten:
**CH DE FR GB IT LI**

(71) Anmelder: **Prokopp, Manfred**
**Kirchäckerstrasse 13**
**D-6980 Wertheim-Waldhausen(DE)**

Anmelder: **Schmidt, Günter, Dipl.-Ing.**
**Steigäckerstrasse 19**
**D-6980 Wertheim-Waldhausen(DE)**

(72) Erfinder: **Prokopp, Manfred**
**Kirchäckerstrasse 13**
**D-6980 Wertheim-Waldhausen(DE)**
Erfinder: **Schmidt, Günter, Dipl.-Ing.**
**Steigäckerstrasse 19**
**D-6980 Wertheim-Waldhausen(DE)**

(74) Vertreter: **Schmitt, Hans, Dipl.-Ing. et al**
**Patentanwälte Dipl.-Ing H. Schmitt Dipl.-Ing.**
**W. Maucher Dreikönigstrasse 13**
**D-7800 Freiburg(DE)**

(54) Leiterplattenprüfgerät.

(57) Eine Grundplatte (1), welche Bestandteil eines Leiterplattenprüfgerätes ist, weist auf ihrer einem Prüfling zugewandten Seite Kontaktflächen (2) auf, die mit einer Durchschaltelektronik od. dgl. Schaltung bzw. einem Rechner verbunden sind. Die Kontaktflächen werden andererseits an die Prüfpunkte einer zu prüfenden Leiterplatte (Prüfling) angeschlossen, um deren Leiterbahnen zu überprüfen. Erfindungsgemäß ist nun vorgesehen, daß Elektronikbausteine unmittelbar an oder in die Grundplatte integriert sind. Die Elektronikbausteine weisen dabei einerseits Anschlüsse zum Verbinden mit den Kontaktflächen (2) und andererseits Steuerleitungen auf. Die Anzahl der Steuerleitungen beträgt dabei nur einen Bruchteil der Anzahl der Kontaktflächen, so daß eine unproblematische Verbindung bzw. Verdrahtung mit einem Rechner möglich ist. Außerdem ergeben sich durch diese Integration der Elektronikbausteine in die Grundplatte wesentliche konstruktive Vereinfachungen.

Fig.2

## Leiterplattenprüfgerät

Die Erfindung betrifft ein Leiterplattenprüfgerät mit einer Grundplatte, welche auf einer Seite eine Vielzahl von z.B. in einem Raster oder prüflingsspezifisch angeordnete Kontaktflächen aufweist, die einerseits mit einer elektrischen, Elektronikbausteine aufweisenden Meßeinrichtung (Rechner) verbunden und andererseits mit Prüfpunkten einer zu prüfenden Leiterplatte über Kontaktnadeln oder Leitgummi od. dgl. verbindbar sind.

Übliche, rechnergesteuerte Leiterplattenprüfgeräte weisen Drahtverbindungen zwischen jeder Kontaktfläche und dem Rechner od. dgl. auf, mit dem die einzelnen Prüfpunkte auf Verbindung bzw. Isolation untereinander überprüft werden können. Diese Drahtverbindungen erfordern in Anbetracht der hohen Anzahl von Kontaktflächen (mehrere Zehntausend) einen erheblichen Aufwand bei der Herstellung. Der sich dabei ergebende Kabelbaum, der mehrere Zentner wiegen kann, hat auch einen entsprechenden Platzbedarf, durch den die Geräte insgesamt recht voluminös sind. Schließlich wirken sich die nicht unerheblichen Leitungskapazitäten nachteilig auf die maximal mögliche Prüffrequenz aus.

Aus der DE-PS 33 40 180 kennt man bereits eine Kontaktfeldanordnung, bei der die Unterseite der Grundplatte Kontaktstifte trägt, an die streifenförmige Leiterplatten mit darauf befindlicher Elektronik über Kontaktstecker angeschlossen werden können. Zur Übertragung der auftretenden Kontaktdrücke, die in der Summe eine beträchtliche Höhe haben können, müssen hierbei Stützstreben vorgesehen sein.

Insgesamt ergibt sich auch bei dieser Vorrichtung ein erheblicher konstruktiver Aufwand, unter anderem um die Grundplatte abzustützen und um die erforderlichen Baugruppen räumlich unterzubringen.

Aufgabe der vorliegenden Erfindung ist es, ein Leiterplattenprüfgerät der eingangs erwähnten Art zu schaffen, welches insbesondere im Bereich der Grundplatte einen gegenüber dem Stand der Technik wesentlich einfacheren konstruktiven Aufbau aufweist und durch den insbesondere auch die Montage und Handhabung vereinfacht sind. Außerdem soll eine geringere Störanfälligkeit vorhanden, gleichzeitig aber eine höhere Prüfgeschwindigkeit möglich sein. Schließlich soll der erforderliche Platzbedarf reduziert sein.

Zur Lösung dieser Aufgabe wird erfindungsgemäß insbesondere vorgeschlagen, daß einer oder mehrere der Elektronikbausteine und seine Anschlüsse für die Kontaktflächen unmittelbar an oder in die Grundplatte integriert sind.

Die Grundplatte selbst beinhaltet somit bereits zumindest einen Teil der Elektronik, so daß die Anzahl der an die Grundplatte anzuschließenden Leitungen erheblich reduziert und z.B. auf Steuerleitungen beschränkt sein kann. Der konstruktive Aufwand, der sonst zur Unterbringung des Kabelbaumes oder von Elektronikbaugruppen zusammen mit entsprechenden Stützkonstruktionen zum Abfangen der Kontaktdrücke erforderlich war, kann dadurch wesentlich verringert werden.

Neben dieser baulichen und fertigungstechnischen Vereinfachung ergeben sich durch die kürzestmöglichen Verbindungen zwischen den einzelnen Kontaktflächen und der Elektronik geringe Leitungskapazitäten und dadurch die Möglichkeit, mit wesentlich höheren Prüfgeschwindigkeiten zu arbeiten.

Eine zweckmäßige Ausführungsform der Erfindung sieht vor, daß die Grundplatte als Leiterplatte, insbesondere als Mehrlagen Leiterplatte (Multilayer) zumindest mit Verbindungsbahnen zwischen den Kontaktflächen und den Anschlüssen der Elektronikbausteine ausgebildet ist. Die Grundplatte ist dadurch gleichzeitig Träger für die Kontaktflächen sowie die Elektronikbausteine und bildet gleichzeitig auch die Leiterplatte zum Verbinden der Kontaktflächen mit den Elektronikbausteinen.

Eine vorteilhafte Ausgestaltung der Erfindung sieht vor, daß die Elektronikbausteine innerhalb des Umrisses der Grundplatte liegen und daß die Grundplatte eine im wesentlichen flächig durchgehende Rückseite aufweist. Dadurch besteht die Möglichkeit, daß die Grundplatte mit ihrer Rückseite flächig auf eine stabile Stützplatte aufgelegt werden kann, so daß Durchbiegungen und dadurch auch Fehlkontaktierungen beim Adaptieren vermieden werden. Außerdem ist eine Stützkonstruktion in Form einer einfachen Platte wesentlich einfacher realisierbar als Stützkonstruktionen, die nur bereichsweise an der Grundplatte angreifen können.

Zweckmäßigerweise enden bei dem bzw. den Elektronikbausteinen zu einzelnen Kontaktflächen führende Leiterbahnen, mit welchen die Anschlüsse der Elektronikbauteile insbesondere direkt verbunden sind. Dadurch ist auf einfache Weise eine Montage der Elektronikbauteile in üblicher Leiterplattenbestückungstechnik oder aber wie beim Verbinden eines Chips mit den Gehäuseanschlüssen möglich.

Zweckmäßigerweise beinhalten die Elektronikbausteine jeweils zumindest eine Durchschaltelektronik, ggf. auch eine Auswerteschaltung, die einerseits Verbindungen zu den Kontaktflächen und andererseits mit einem Rechner verbindbare Steuerleitungen aufweisen. Durch die Integration dieser Elektronikbausteine in die Grundplatte wird die erforderliche Anzahl von Anschlußleitungen wesentlich reduziert und beträgt nur noch ein Bruchteil der vorhandenen Anzahl von Kontaktflächen. Beispielsweise kommt man für eine Anzahl von mehreren Zehntausend Kontakt flächen mit weniger als zum Beispiel 50 Steuerleitungen aus.

Zweckmäßigerweise sind die Steuerleitungen seitlich an den Rand der Grundplatte herausgeführt und es sind dort vorzugsweise Kontaktstellen zum Anschließen von Bus- und Decoderleitungen od. dgl. Steuerleitungen vorgesehen. Diese Anschlüsse liegen somit außerhalb des aktiven und mit Kontaktflächen versehenen Grundplatten-Bereiches, so daß hier auch keine Stützkonstruktionsteile zum Abfangen von Kontaktierdruck erforderlich sind. Außerdem lassen sich die wenigen Steuerleitungen am Rand der Grundplatte auch gut anschließen.

Eine Ausgestaltung der Erfindung sieht vor, daß die Grundplatte durch mehrere, vorzugsweise streifenförmige Teilplatten mit jeweils zugehöriger und in die Teilplatten integrierter Elektronik ausgebildet sind. Dadurch lassen sich Grundplatten mit unterschiedlicher Grundfläche und unterschiedlicher Anzahl von Kontaktflächen zusammenstellen. Außerdem lassen sich diese einzelnen Teilplatten bei Verschleiß oder bei aufgetretenen Fehlern einfach und kostengünstig auswechseln.

Eine andere Ausführungsform der Erfindung sieht vor, daß die Grundplatte eine Bestückung mit Kontaktflächen entsprechend der Prüfpunkte-Anordnung des Prüflings aufweist. Die Anzahl der Kontaktflächen entspricht hierbei der tatsächlichen Anzahl der Prüfpunkte und ist somit wesentlich geringer als bei einer Grundplatte mit in einem Raster angeordneten Kontaktflächen. Insbesondere bei geringerer Anzahl von Prüfpunkten und großen Stückzahlen von Prüflingen kann diese Anordnung vorteilhaft sein. Die Grundplatte ist somit zusammen mit der integrierten Elektronik speziell auf einen bestimmten Prüfling zugeschnitten. Durch die erfindungsgemäße Ausbildung der Grundplatte ist der Aufwand für deren Herstellung vergleichsweise gering, so daß auch eine spezielle, prüflingsbezogene Grundplatte wirtschaftlich herstellbar ist.

Zusätzliche Ausgestaltungen der Erfindung sind in den weiteren Unteransprüchen aufgeführt. Nachstehend ist die Erfindung mit ihren wesentlichen Einzelheiten anhand der Zeichnungen noch näher erläutert.

Es zeigt:

Fig. 1 eine Teilaufsicht einer Grundplatte und

Fig. 2 eine etwas schematisierte Teilschnittdarstellung einer Grundplatte.

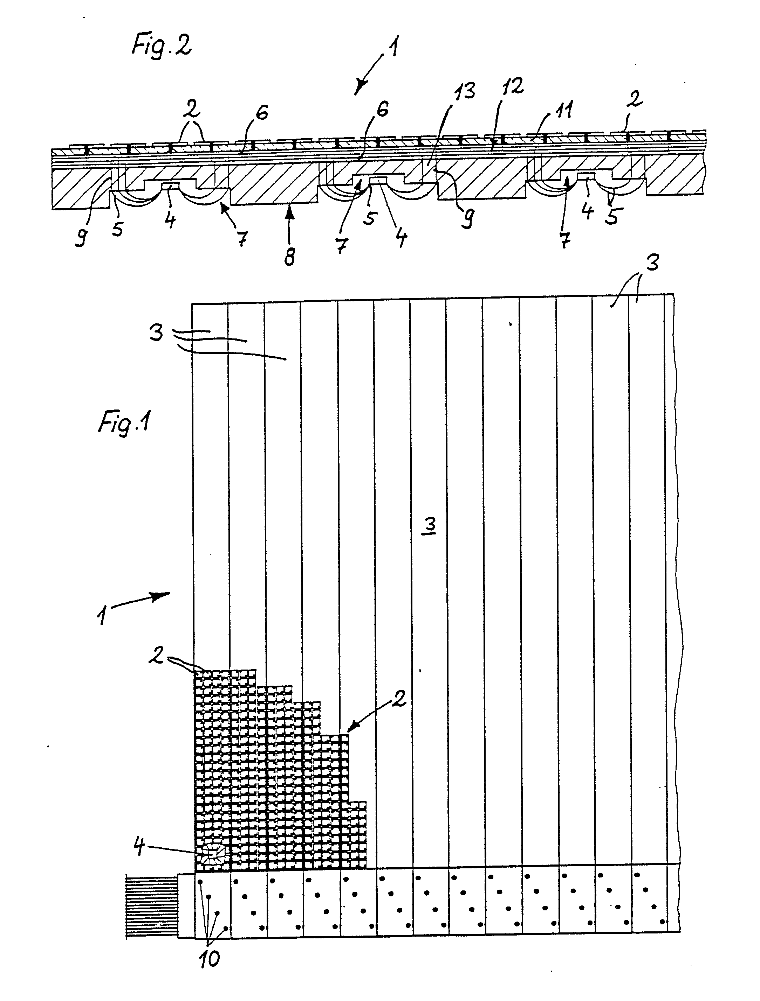

Eine in Fig. 1 gezeigte Grundplatte 1 ist Teil eines Leiterplattenprüfgerätes, mit dem Leiterplattenprüflinge vor dem Bestücken mit Bauteilen überprüft werden können. Die einzelnen Prüfpunkte des Prüflings werden dabei kontaktiert und mit auf der Grundplatte 1 befindlichen Kontaktflächen 2 verbunden. In Fig. 1 sind der Einfachheit halber nur ein Teil dieser Kontaktflächen 2 dargestellt, die zum Beispiel in einem Zehntelzollraster angeordnet sein können.

Im gezeigten Ausführungsbeispiel ist die Grundplatte 1 durch mehrere, nebeneinander angeordnete, streifenförmige Teilplatten 3 gebildet.

Die einzelnen Kontaktflächen, von denen während des Prüfvorganges eine Anzahl mit Prüfpunkten des Prüflings verbunden sind, sind mit Elektronikbausteinen verbunden, welche ihrerseits entweder Bestandteil eines Rechners oder aber an einem solchen angeschlossen sind.

Erfindungsgemäß ist vorgesehen, daß einer oder mehrere Elektronikbausteine 4 und seine Anschlüsse 5 für die Kontaktflächen 2 unmittelbar an oder in die Grundplatte 1 integriert sind. Die Grundplatte 1 selbst beinhaltet somit auch zumindest einen Teil der erforderlichen Elektronik. Je nach Größe der Grundplatte 1 und der Anzahl von Kontaktflächen 2 können ein oder wenige Elektronikbausteine oder aber eine Vielzahl von Elektronikbausteinen 4 vorgesehen sein. Bei einer Grundplatte 1 mit im Raster angeordneten Kontaktflächen 2 wie dies in den Figuren dargestellt ist, sind im Ausführungsbeispiel mehrere Elektronikbausteine 4 vorgesehen, die jeweils einer bestimmten Anzahl von Kontaktflächen 2 zugeordnet ist.

Die Grundplatte 1 ist zweckmäßigerweise als Leiterplatte ausgebildet, um die Leitungsverbindungen zwischen den Kontaktflächen 2 und dem bzw. den Elektronikbausteinen 4 herstellen zu können. In Fig. 2 ist angedeutet, daß wegen der Vielzahl von Verbindungen die Leiterbahnen 6 in mehreren Lagen übereinander angeordnet sind (Multilayer).

Die Elektronikbausteine 4 sind in Vertiefungen 7 auf der Rückseite 8 der Grundplatte eingesetzt, wobei sie hier auch innerhalb des Umrisses der Grundplatte liegen. Dadurch ergibt sich rückseitig eine flächig durchgehende Rückseite der Grundplatte als Auflage auf einer Stützplatte. Andererseits besteht aber auch die Möglichkeit, die Grundplatte 1 selbst so dick und stabil auszubilden, daß sie die auftretenden Kontaktkräfte aufnehmen kann.

Die zu den einzelnen Kontaktflächen 2 führenden Leiterbahnen 6 sind zum Beispiel über durchkontaktierte Bohrungen zu den Vertiefungen 7 od. dgl. Stellen zum Plazieren der Elektronikbausteine 4 geführt, so daß dort direkt die Anschlüsse der Elektronikbausteine verbindbar sind. Die Verbindungen zwischen den Elektronikbausteinen 4 und den Leiterbahnen 6 bzw. den durchkontaktierten Bohrungen 9 können Lötverbindungen oder gebondete Verbindungen, wie sie bei der Herstellung von integrierten Schaltkreisen üblich sind, sein. Im letzteren Falle können die Elektronikbausteine in Chipform an der Grundplatte 1 angebracht werden und dann durch Bonden mit den Anschlußenden der Leiterbahnen 6 verbunden werden. Danach kann zum Schutz der Chips eine Vergußmasse aufgebracht werden. Dabei besteht auch die Möglichkeit, die Vertiefungen 7 mit Kunstharzmasse auszugießen, so daß eine durchgehend geschlossene Rückseite 8 vorhanden ist. Auch bei Verwendung von Elektronikbausteinen in üblicher Bauform, z.B. von SMD-Bauteilen ist das Vergießen der Aufnahmevertiefungen 7 für die Bausteine möglich.

Die Elektronikbausteine 4 sind einerseits an Leiterbahnen 6 angeschlossen, die zu den Kontaktflächen 2 führen und weisen außerdem Anschlußverbindungen auf, die an den Rand der Grundplatte 1 herausgeführt und dort an Bus- und Decoderleitungen bzw. Steuerleitungen angeschlossen sind, die z.B. mit einem Rechner verbunden sind. Durch die in die Grundplatte 1 bzw. die Teilplatten 3 integrierten Elektronikbausteine 4 sind jedoch im Vergleich zur Anzahl der Kontaktflächen 2 nur eine sehr geringe Anzahl von herauszuführenden Steuerleitungen erforderlich. Die Verbindung der von den Elektronikbausteinen 4 kommenden Steuerleitungen mit den Bus- und Decoderleitungen kann über Kontaktstellen 10 , z.B. über Federkontakte erfolgen.

In Fig. 2 ist noch erkennbar, daß die als Mehrlagenplatte ausgebildete Grundplatte 1 eine Trägerschicht 11 für die Kontaktflächen 2 , der Kontaktflächen-Seite abgewandt, die vorzugsweise in Multilayer-Technik angeordneten Leiterbahnen 6 in einer Leiterbahnenschicht 12 und eine Aufnahmeschicht 13 für die Elektronikbausteine 4 aufweist. Diese einzelnen Schichten sind miteinander verbunden und bilden die Grundplatte 1 .

Wie bereits vorerwähnt, ist die Grundplatte 1 im Ausführungsbeispiel mit in einem Grundraster angeordneten Kontaktflächen 2 belegt. Man erhält dadurch eine Universal-Grundplatte 1 , mit der zu prüfende Leiterplatten mit unterschiedlich angeordneten Prüfpunkten getestet werden können. Die Anzahl der Kontaktflächen 2 auf einer Gesamt-Grundplatte 1 kann dabei mehrere Zehntausend betragen. Die Anzahl der Prüfpunkte beträgt in der Regel jedoch einige Hundert bis einige Tausend. Die Zuordnung der Prüfpunkte des Prüflings zu den entsprechenden Kontaktflächen 2 der Grundplatte kann durch prüflingsspezifisch angeordnete Kontaktnadeln oder, insbesondere bei hoher Prüfpunktedichte auch durch eine Leitgummizwischenlage erfolgen. Durch den einfachen Aufbau der Grundplatte 1 mit erfindungsgemäß integrierter Elektronik besteht aber auch die Möglichkeit, die Grundplatte selbst mit einer Kontaktflächen-Anordnung entsprechend den Prüfpunkten des Prüflings zu versehen. In diesem Falle weist die Grundplatte 1 dementsprechend eine Anzahl von Kontaktflächen 2 auf, die der der Prüfpunkte entspricht. Durch die geringere Anzahl von Kontaktflächen ist der Aufwand für die Grundplatte zusätzlich reduziert, so daß sich diese Ausführungsform der Grundplatte auch schon bei geringeren Stückzahlen von Prüflingen wirtschaftlich einsetzen läßt. Erwähnt sei in diesem Zusammenhang, daß sich bei einer prüflingsspezifischen Ausbildung der Grundplatte auch auf deren Oberseite - dem Prüfling zugewandt - Bereiche ergeben können, in denen keine Kontaktflächen 2 vorhanden sind, so daß die Möglichkeit besteht, bei dieser Ausführungsform die Elektronikbausteine 4 auch von der Oberseite (Kontaktflächenseite 2 her einzusetzen. Je nach Prüfpunktedichte kann auch sowohl oberseitig als auch unterseitig eine Anordnung von Elektronikbausteinen 4 vorgesehen sein. Die Elektronikbausteine können jeweils zumindest eine Durchschaltelektronik, ggf. auch eine Auswerteschaltung beinhalten. Insbesondere sind die Elektronikbausteine so ausgebildet, daß ihre Steuerleitungsanschlüsse Schnittstellen zum Anschluß an einen Rechner bilden.

Insgesamt erhält man bei dem erfindungsgemäßen Leiterplattenprüfgerät durch die in die Grundplatte 1 integrierte (Durchschalt-)Elektronik einen sehr kompakten Aufbau der Vorrichtung und auch eine sehr einfache Handhabung, da die erforderliche Verbindung zwischen der erfindungsgemäßen Grundplatte und einem Rechner über vergleichsweise wenige Steuerleitungen erfolgen kann. Der Aufbau der Grundplatte ermöglicht auch eine besonders einfache Unterstützung, um die auftretenden Kontaktdruckkräfte abfangen zu können. Insbesondere läßt sich die Grundplatte 1 selbst als entsprechend stabile Platte ausbil den oder aber man kann diese flächig auf eine stabile Stützplatte auflegen. Durch die in die Grundplatte integrierte Elektronik sind auch kürzestmögliche Verbindungen zu den Kontaktflächen 2 vorhanden, so daß schädliche Leitungskapazitäten sehr klein gehalten werden können. Dadurch besteht die Möglichkeit, mit sehr hohen Prüffrequenzen zu arbeiten und somit die Prüfzykluszeit klein zu halten. Im Endeffekt ergibt dies die Möglichkeit, in einer bestimmten Zeiteinheit mehr Leiterplatten prüfen zu können, was bei Großserienprüfungen von erheblicher Bedeutung ist.

Alle in der Beschreibung, den Ansprüchen und der Zeichnung dargestellten Merkmale können sowohl einzeln als auch in beliebiger Kombination miteinander erfindungswesentlich sein.

## Ansprüche

1. Leiterplattenprüfgerät mit einer Grundplatte, welche auf einer Seite eine Vielzahl von z.B. in einem Raster oder prüflings-spezifisch angeordnete Kontaktflächen aufweist, die einerseits mit einer elektrischen, Elektronikbausteine aufweisenden Meßeinrichtung (Rechner) verbunden und andererseits mit Prüfpunkten einer zu prüfenden Leiterplatte über Kontaktnadeln oder Leitgummi od. dgl. verbindbar sind, **dadurch gekennzeichnet, daß** einer oder mehrere der Elektronikbausteine (4) und seine Anschlüsse (5) für die Kontaktflächen (2) unmittelbar an oder in die Grundplatte (1) integriert sind.

2. Leiterplattenprüfgerät nach Anspruch 1, dadurch gekennzeichnet, daß die Grundplatte (1) als Leiterplatte, insbesondere als Mehrlagen-Leiterplatte (Multilayer) zumindest mit Verbindungsbahnen (6) zwischen den Kontaktflächen (2) und den Anschlüssen der Elektronikbausteine (4) ausgebildet ist.

3. Leiterplattenprüfgerät nach Anspruch 1 oder 2, dadurch gekennzeichnet, daß die Grundplatte (1) Vertiefungen (7) für Elektronikbausteine (4) aufweist.

4. Leiterplattenprüfgerät nach einem oder mehreren der Ansprüche 1 bis 3, dadurch gekennzeichnet, daß die Elektronikbausteine (4) auf der der Kontaktflächen-Seite abgewandten Rückseite (8) der Grundplatte (1) angeordnet sind.

5. Leiterplattenprüfgerät nach einem oder mehreren der Ansprüche 1 bis 4, dadurch gekennzeichnet, daß die Elektronikbausteine (4) innerhalb des Umrisses der Grundplatte (1) liegen und daß die Grundplatte (1) eine im wesentlichen flächig durchgehende Rückseite (8) aufweist.

6. Leiterplattenprüfgerät nach einem oder mehreren der Ansprüche 1 bis 5, dadurch gekennzeichnet, daß bei dem bzw. den Elektronikbausteinen (4) zu einzelnen Kontaktflächen (2) führende Leiterbahnen (6) enden, mit welchen die Anschlüsse (5) der Elektronikbauteile insbesondere direkt verbunden sind.

7. Leiterplattenprüfgerät nach einem oder mehreren der Ansprüche 1 bis 6, dadurch gekennzeichnet, daß die Verbindungen zwischen den Elektronikbausteinen (4) und den Leiterbahnen (6) der Grundplatte (1) Lötverbindungen oder gebondete Verbindungen sind.

8. Leiterplattenprüfgerät nach einem oder mehreren der Ansprüche 1 bis 7, dadurch gekennzeichnet, daß die Elektronikbausteine (4) in Chipform ausgebildet sind und daß eine nach dem Erstellen der Anschlußverbindungen vorzugsweise durch Bonden, aufgebrachte Vergußmasse, insbesondere als Schutz vorgesehen ist.

9. Leiterplattenprüfgerät nach einem oder mehreren der Ansprüche 1 bis 8, dadurch gekennzeichnet, daß die Elektronikbausteine (4) als SMD-Bauteile ausgebildet sind.

10. Leiterplattenprüfgerät nach einem oder mehreren der Ansprüche 1 bis 9, dadurch gekennzeichnet, daß die Grund platte (1) als Mehrschichtplatte ausgebildet ist und eine Trägerschicht (11) für die Kontaktflächen (2), darauf, der Kontaktflächen-Seite abgewandt, eine oder mehrere Leiterbahnschichten (12) und darauf eine Aufnahmeschicht (13) vorzugsweise mit Ausnehmungen (7) für die Elektronikbausteine (4) aufweist.

11. Leiterplattenprüfgerät nach einem oder mehreren der Ansprüche 1 bis 10, dadurch gekennzeichnet, daß Gruppen von Kontaktflächen (2) jeweils ein Elektronikbaustein (4) zugeordnet ist.

12. Leiterplattenprüfgerät nach einem oder mehreren der Ansprüche 1 bis 11, dadurch gekennzeichnet, daß die Elektronikbausteine (4) jeweils zumindest eine Durchschaltelektronik, ggf. auch eine Auswerteschaltung beinhalten, und daß sie einerseits Verbindungen zu den Kontaktflächen (2) und andererseits mit einem Rechner od. dgl. verbindbare Steuerleitungen aufweisen.

13. Leiterplattenprüfgerät nach einem oder mehreren der Ansprüche 1 bis 12, dadurch gekennzeichnet, daß die Steuerleitungen seitlich an den Rand der Grundplatte (1) herausgeführt sind und daß dort vorzugsweise Kontaktstellen (10) zum Anschließen von Bus- und Decoderleitungen od. dgl. Steuerleitungen vorgesehen sind.

14. Leiterplattenprüfgerät nach einem oder mehreren der Ansprüche 1 bis 13, dadurch gekennzeichnet, daß die Grundplatte (1) durch mehrere, vorzugsweise streifenförmige Teilplatten (3) mit jeweils zugehöriger und in die Teilplatten (3) integrierter Elektronik ausgebildet sind.

15. Leiterplattenprüfgerät nach einem oder mehreren der Ansprüche 1 bis 14, dadurch gekennzeichnet, daß die Grund platte (1) eine Bestückung mit Kontaktflächen (2) entsprechend der Prüfpunkte-Anordnung der zu prüfenden Leiterplatte (Prüfling) aufweist.

Fig.2

Fig.1